# EUROPEAN PATENT APPLICATION

(11) **EP 4 776 835 A1**
(43) Date of publication of application: **15.07.2026**
(21) Application number: 26151020.0
(22) Date of filing: 09.01.2026
(51) Int. Cl.: H10W 40/60, H10W 40/47, H10W 40/20, H10W 76/63, H10W 76/40, H10W 40/25

(54) **COOLING ASSEMBLIES FOR INTEGRATED CIRCUITS**

(30) Priority: 10.01.2025 US 202519016504
(71) Applicant: Avago Technologies International Sales Pte. Limited, Singapore 768923 (SG)
(72) Inventor: Theil, Jeremy Alfred, Mountain View, CA 94040 (US); Zhao, Sam Ziqun, Irvine, CA 92618 (US)
(74) Representative: Dilg, Haeusler, Schindelmann Patentanwaltsgesellschaft mbH

(57) **Abstract**

Cooling assemblies that can be used with various types of integrated circuits to provide improved efficiency. An example integrated circuit includes a circuit die, a stiffener ring, a heat exchange structure, and a cover plate disposed on the heat exchange structure; and a clamp secured to the cover plate. The integrated circuit can also include a seal disposed between the cover plate and the heat exchange structure, where the seal prevents leakage of fluid that circulates through the heat exchange structure.

## Description

### BACKGROUND

The present disclosure relates, in general, to packaging and thermal management of various types of electronic circuits and associated technologies. As electronic circuits continue to become more advanced and smaller in size, they generate more heat and become more difficult to cool. Accordingly, new technologies that can help with managing the thermal characteristics of electronic circuits are generally desired.

### BRIEF DESCRIPTION OF THE DRAWINGS

FIG. 1 shows a cross section illustrating example components of an example integrated circuit, in accordance with some aspects of the disclosure.
FIG. 2 shows a cross section further illustrating an example heat exchange structure of the integrated circuit of FIG. 1, in accordance with some aspects of the disclosure.
FIG. 3 shows a cross section illustrating an example temporary lid that can be used during the fabrication process for the integrated circuit 100 of FIG. 1, in accordance with some aspects of the disclosure.
FIG. 4 shows another cross section illustrating example components of another example integrated circuit, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

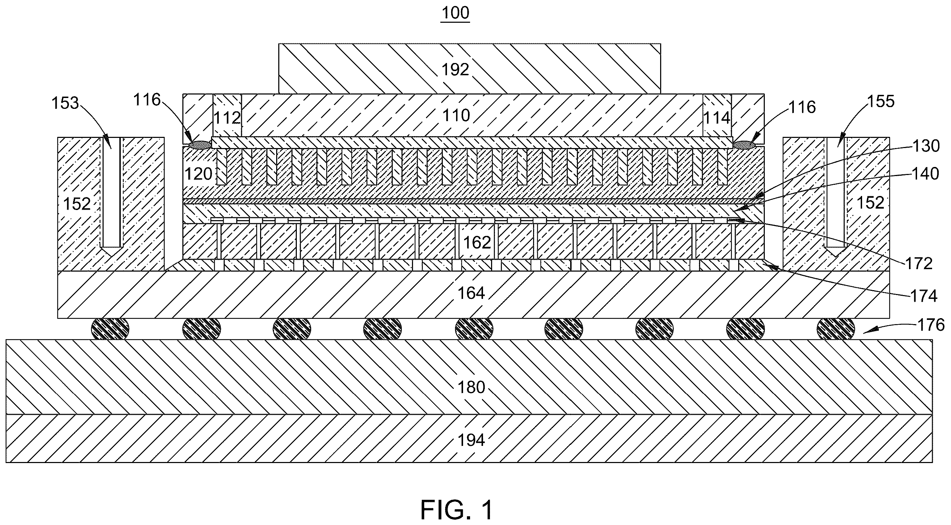

Referring to FIG. 1, a cross section that illustrates example components of an example integrated circuit 100 is shown, in accordance with some aspects of the disclosure. The integrated circuit 100 can be designed for a variety of suitable purposes, and can be included in a variety of suitable types of electronic devices. For example, the integrated circuit 100 can be implemented in a data center to provide data processing and/or other functionality (e.g., via one or more central processing units (CPUs), graphics processing units (GPUs), etc.). The integrated circuit 100 can also be implemented in various types of personal computing devices (e.g., smartphones, personal computers, etc.) and networking devices (e.g., network switch devices, communications circuits. etc.). The integrated circuit 100 can be used for various artificial intelligence (AI) applications (e.g., for training and/or inference).

As shown in FIG. 1, the integrated circuit 100 can include a cover plate 110, a heat exchange structure 120, a interface material layer 130, a circuit die 140, a stiffener ring 152, an interposer layer 162, and a substrate 164. Also, as shown in FIG. 1, the cover plate 110 can include a first port 112 and a second port 114, where the first port 112 can be used to receive a fluid for circulating through the heat exchange structure 120 and the second port 114 can then be used to remove the fluid after circulating through the heat exchange structure 120 (or vice versa). Additionally, as shown in FIG. 1, the integrated circuit 100 can include a seal 116 that can be disposed between the cover plate 110 and the heat exchange structure 120 for preventing leakage of the fluid. Further, the integrated circuit 100 can include a clamp 192 that can be secured to the cover plate 110 to oppose the hydrostatic pressure generated by the fluid when the fluid circulates through the heat exchange structure 120.

Moreover, as shown in FIG. 1, the integrated circuit 100 can include or can be mounted to a circuit board 180. Also, a pressure support plate (cradle) 194 can be secured to the circuit board 180, where the pressure support plate 194 can also oppose the hydrostatic pressure generated by the fluid when the fluid circulates through the heat exchange structure 120, in connection with the clamp 192. Also shown in FIG. 1, the integrated circuit 100 can include an interconnect layer 172 disposed between the circuit die 140 and the interposer layer 162 and an interconnect layer 174 disposed between the interposer layer 162 and the substrate 164. Likewise, an interconnect layer 176 can be disposed between the substrate 164 and the circuit board 180. In some examples, the interconnect layer 176, the circuit board 180, the clamp 192, and the pressure support plate 194 can be considered part of the integrated circuit 100 (e.g., when the integrated circuit 100 is interpreted as a higher level system circuit (chip) including other dies similar to the circuit die 140 mounted to the circuit board 180). In other examples, the interconnect layer 176, the circuit board 180, and the pressure support plate 194 can be considered part of a broader circuit in which the integrated circuit 100 is included (e.g., when the integrated circuit 100 is interpreted as a lower level circuit (chip) containing primarily the circuit die 140). For example, the substrate 164, the interconnect layer 174, the stiffener ring 152, the interposer layer 162, the interconnect layer 172, the circuit die 140, the interface material layer 130, the heat exchange structure 120, the seal 116, and/or the cover plate 110 (including the first port 112 and the second port 114) can be together included in a single integrated circuit package. Then, the circuit board 180 can be a printed circuit board substrate on which the integrated circuit package is disposed on and interconnected to via the interconnect layer 176. As such, depending on the implementation, the integrated circuit 100 may or may not include all elements as shown in FIG. 1.

The circuit die 140 can be implemented in various suitable manners. For example, the circuit die 140 can be implemented using a single circuit die, and the circuit die 140 can also be implemented as using multiple circuit dies. The circuit die 140 can be formed using silicon material, for example, and the circuit die 140 can be formed using various suitable fabrication techniques. For example, multiple circuit dies can be combined to form the circuit die 140 using a 2.5D packaging technique. In such examples, the multiple circuit dies can be combined using through-silicon vias, such that the multiple circuit dies can be disposed side-by-side on the interconnect layer 172 (which is disposed on the interposer layer 162) and connected by way of the through-silicon vias. Additionally, the circuit die 140 can be formed by stacking multiple circuit dies (e.g., using a 3D packaging technique) on each other. For example, a die stack can be formed using techniques such as thermocompression bonding (TCB), hybrid copper bonding (HCB), and/or other suitable techniques. The circuit die 140 can include various types and combinations of electrical components (e.g., transistors, resistors, capacitors, inductors, semiconductors, etc.) and can be designed to perform various suitable functions.

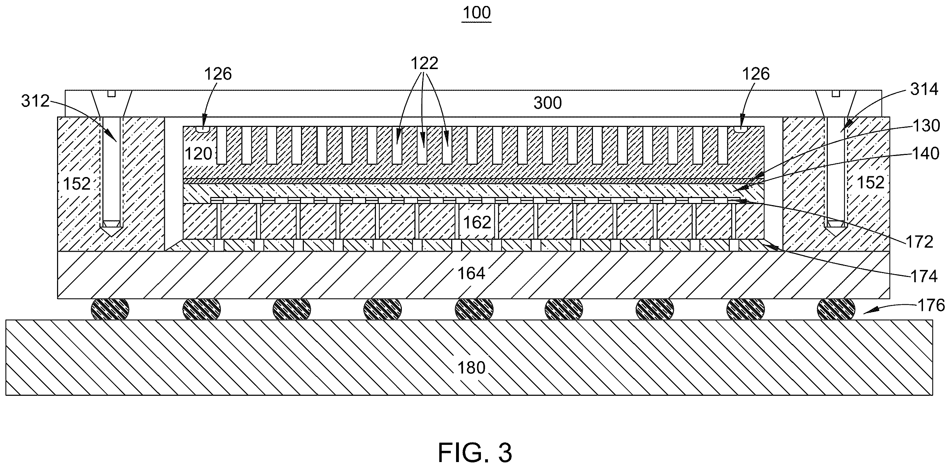

The stiffener ring 152 can be disposed on the substrate 164, as shown in FIG. 1, and can be implemented in various suitable manners. The stiffener ring 152 can, in general, provide structural support for the packaging of the integrated circuit 100. The stiffener ring 152 can be formed on a surface of the substrate 164 that is opposite the circuit board 180, as shown in FIG. 1. The stiffener ring 152 can be secured to the substrate 164 using various suitable techniques (e.g., using an adhesive). As shown in FIG. 1, the stiffener ring 152 can optionally include a first hole 153 and a second hole 155 that can receive fasteners (as detailed further below with respect to FIG. 3). The stiffener ring 152 can be formed using various suitable materials, including using suitable metals (e.g., copper, stainless steel, aluminum, etc.), alloys, and/or other suitable materials, for example. The circuit die 140 can generally be disposed within the stiffener ring 152 on the substrate 164, as shown in FIG. 1.

The cover plate 110 can be disposed on the heat exchange structure 120, as shown in FIG. 1, and can be implemented in various suitable manners. The cover plate 110 can be formed using various suitable materials such as, copper, stainless steel, aluminum, and/or other suitable materials, for example. The top surface of the cover plate 110 (closest to the clamp 192 from the perspective shown in FIG. 1) and the bottom surface of the cover plate 110 (closest to the heat exchange structure 120 from the perspective shown in FIG. 1) can both generally be flat surfaces. Additionally, the first port 112 and the second port 114 can be designed to hold up against the maximum pressure drops experienced by the integrated circuit 100 resulting from the flow of the fluid through the heat exchange structure 120 (e.g., from inlet to outlet, from opening to ambient, etc.). The cover plate 110 can generally be considered a manifold cover that is part of a cooling assembly for the integrated circuit 100. The cover plate 110 and the stiffener ring 152 can consist of essentially the same materials, or the cover plate 110 and the stiffener ring 152 can consist of different materials.

The seal 116 can likewise be implemented in various suitable manners. For example, the seal 116 can be implemented using adhesive material, rubber, solder material, and/or using other suitable materials. The seal 116 can be implemented as an O-ring type seal, in some examples. Generally, the seal 116 can be disposed between the cover plate 110 and the heat exchange structure 120 to preventing leakage of the fluid flowing to, from, and through the heat exchange structure 120. The fluid can be any suitable type of fluid, including water, air, various types of coolants, and/or other types of fluids. The seal 116 can generally be designed to have the proper metallization and seal width for the particular implementation of the integrated circuit 100. Additionally, the height (thickness) of the seal 116 (e.g., as measured in a direction between the cover plate 110 and the heat exchange structure 120) can be set to a desired level during the fabrication process of the integrated circuit 100 (e.g., through compression, through mechanical stops, etc.), as deemed appropriate for the particular implementation of the integrated circuit 100.

The interposer layer 162 can be used to form various electrical connections within the integrated circuit 100. For example, as noted, the interposer layer 162 can be used to electrically connect multiple dies that are used to form the circuit die 140. Use of the interposer layer 162 can provide various advantages, including spreading connections to a wider pitch, providing a flexible interface, eliminating packaging layers from the integrated circuit 100, lowering latency between electrical connections, providing higher bandwidth density, providing efficient energy utilization, and/or other possible advantages, depending on the application. The circuit die 140, the interconnect layer 172, and the interposer layer 162 can cooperatively form a "die on interposer" (DOI) structure within the integrated circuit 100. In some implementations of the integrated circuit 100 (e.g., when the circuit die 140 is implemented as a single die), the interposer layer 162 and at least one of the interconnect layer 172 or the interconnect layer 174 may not be included as part of the integrated circuit 100.

The substrate 164 can be implemented in various suitable manners, and the substrate 164 can generally serve as a base for forming various components of the integrated circuit 100 thereon. For example, the substrate 164 can be formed using organic materials and/or other suitable materials or combinations of materials. The substrate 164 can generally be coupled to a lid to from a package as part of the integrated circuit 100 (e.g., the integrated circuit package referenced above). The circuit board 180 can likewise be implemented in various suitable manners. For example, the circuit board 180 can be implemented using various suitable types of printed circuit boards (PCBs).

The interconnect layer 172, the interconnect layer 174, and the interconnect layer 176 can each be implemented in various suitable manners, depending on the particular implementation of the integrated circuit 100. For example, the interconnect layer 172 can be formed using approaches such as reflow soldering interconnection, thermocompression bonding, hybrid copper bonding, and/or other suitable approaches. To help distribute forces during compression and to help with hydrostatic loading, the interconnect layer 172 can consist essentially of solid materials. The solid materials can include various suitable metals (e.g., copper, aluminum, etc.), metal alloys (e.g., solder, etc.), dielectric materials (e.g., silicon oxide, silicon dioxide, silicon nitride, aluminum oxide, etc.), and/or other suitable solid materials.

The interconnect layer 174 can be formed, for example, using a controlled chip collapse interconnection (sometimes referred to as C4, flip chip, etc.) or by using bump metallization (sometimes referred to as under bump metallization (UBM) or a ball grid array (BGA)). The interconnect layer 174 can further include underfill material (e.g., epoxy, polymer, etc.). For example, the underfill material can be formed at least partially around the bumps or balls. Similar to the interconnect layer 172, the interconnect layer 174 can consist essentially of solid materials (e.g., metals, metal alloys, dielectric materials, etc.) to help distribute forces during compression and to help with hydrostatic loading. The interconnect layer 176 can likewise be formed using bump metallization, among other possible approaches, and can also include underfill material. Similar to the interconnect layer 172 and the interconnect layer 174, the interconnect layer 176 can consist essentially of solid materials (e.g., metals, metal alloys, dielectric materials, etc.) to help distribute forces during compression and to help with hydrostatic loading.

The clamp 192 and the pressure support plate 194 can be implemented in various suitable manners, and can generally provide structure to oppose the hydrostatic pressure generated by the fluid circulating through the heat exchange structure 120. The clamp 192 and the pressure support plate 194 can be formed using various suitable materials, including various suitable types of metals (e.g., copper, stainless steel, aluminum, etc.) and/or other materials. The pressure support plate 194 can generally support the back side of the circuit board 180 to balance the force exerted by the clamp 192. In some implementations, the circuit board 180 can have enough structural rigidity such that the use of the pressure support plate 194 may not be required for use. Additionally, in implementations where the integrated circuit 100 does not include (or is not attached to) the circuit board 180 via the interconnect layer 176, the pressure support plate 194 can be secured to or otherwise in contact with the bottom surface of the substrate 164 (e.g., the surface of the substrate 164 opposite the interconnect layer 174, the interposer layer 162, and the circuit die 140) to support the back side of the substrate 164 and balance force exerted by the clamp 192. Any combination of the clamp 192, the stiffener ring 152, and the cover plate 110 can be fabricated as (integrated into) a single part to provide efficiencies during the fabrication process for the integrated circuit 100 and/or improved performance of the integrated circuit 100.

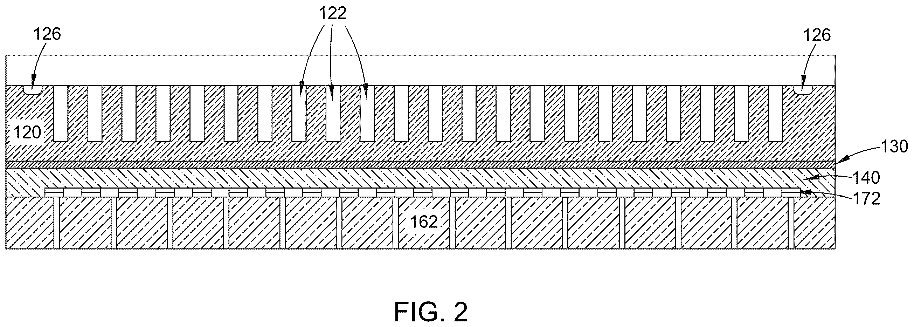

Referring to FIG. 2, a cross section that further illustrates the heat exchange structure 120 of the example integrated circuit 100 is shown, in accordance with some aspects of the disclosure. In particular, the cross section shown in FIG. 2 illustrates the heat exchange structure 120 before the cover plate 110 is disposed on the heat exchange structure 120 and before the seal 116 is formed between the cover plate 110 and the heat exchange structure 120. As can be seen in FIG. 2, the heat exchange structure 120 can include openings 122 and a groove 126. The openings 122 can generally be formed within the heat exchange structure 120 to increase the surface area of the heat exchange structure 120 and generally increase the cooling efficiency that can be provided by the heat exchange structure 120. Advantageously, the heat exchange structure 120 can be provided within the same package as the circuit die 140 to provide ease of assembly (e.g., on the circuit board 180).

The openings 122 can be implemented in various suitable manners, and the openings 122 can include any suitable number of openings (e.g., one opening, ten openings, fifteen openings, twenty two openings as shown in FIG. 2, etc.). The fluid that circulates through the heat exchange structure 120 can circulate at least partially through the openings 122. The openings 122 can include fins, posts, pillars, and/or any other suitable opening structure. The groove 126 can be formed in a top surface of the heat exchange structure 120 (e.g., the surface of the heat exchange structure 120 opposite the circuit die 140) such that the seal 116 can be disposed within the groove 126 and prevent leakage of the fluid. The groove 126 can have various suitable dimensions and characteristics, depending on the intended implementation of the seal 116.

In some implementations, the heat exchange structure 120 can consist essentially of silicon. For example, the heat exchange structure 120 can be fabricated as a "silicon microchannel support" (SMS) that is bonded to a die-on-interposer (DOI) structure, where the DOI structure includes the interface material layer 130, the circuit die 140, the interconnect layer 172, and the interposer layer 162. The heat exchange structure 120 can be implemented as a die or a wafer, for example, among other possible implementations. The interface material layer 130 can be implemented in various suitable ways depending on the implementation of the integrated circuit 100. For example, the interface material layer 130 can include a dielectric material (e.g., silicon oxide, silicon dioxide, silicon nitride, aluminum oxide, etc.). In such examples, the interface material layer 130 can be made especially thin such that the interface material layer 130 has a low thermal resistance. When the interface material layer 130 includes a dielectric material, a thickness of the interface material layer 130 as measured in the direction between the circuit die 140 and the heat exchange structure 120 can be between 80 nanometers and 50 micrometers.

The interface material layer 130 can additionally or alternatively include a solder material (e.g., high temperature solder alloys such as indium silver, gallium, tin silver, tin copper, etc.). In such examples, the interface material layer 130 can also be made rather thin such that the interface material layer 130 has a low thermal resistance. The high thermal conductivity of the solder material can also lower the thermal resistance of the interface material layer 130 in such examples. When the interface material layer 130 includes a solder material, a thickness of the interface material layer 130 as measured in the direction between the circuit die 140 and the heat exchange structure 120 can be between 900 nanometers and 200 micrometers. Additionally, the interface material layer 130 can include an indium alloy, in some implementations.

The heat exchange structure 120 can be bonded to the circuit die 140 via the interface material layer 130 in various suitable manners during the fabrication process for the integrated circuit 100. For example, a fusion bonding process can be used, where a dielectric material can be applied (e.g., using various suitable deposition processes, etc.) to both a bottom surface of the heat exchange structure 120 (e.g., the surface closest to the circuit die 140) and a top surface of the circuit die 140 (e.g., the surface closest to the heat exchange structure 120). A chemical mechanical planarization (CMP) process can then be used on both the bottom surface of the heat exchange structure 120 and the top surface of the circuit die 140 before using a fusion bonding process to bond the bottom surface of the heat exchange structure 120 to the top surface of the circuit die 140 via the interface material layer 130. Due to the circulation of cold fluid through the heat exchange structure 120, the heat exchange structure 120 can serve as a "cold plate" that can provide cooling for the circuit die 140 within the integrated circuit 100, for example.

As another example, a solder bonding process can be used, where metallization and solder plating can be applied (e.g., using various suitable processes) to both the bottom surface of the heat exchange structure 120 and the top surface of the circuit die 140 before using a reflow soldering process to bond the bottom surface of the heat exchange structure 120 to the top surface of the circuit die 140 via the interface material layer 130. In implementations where the heat exchange structure 120 is a die, the bonding process used to bond the heat exchange structure 120 to the circuit die 140 via the interface material layer 130 can be a die to wafer (D2W) bonding process. In implementations where the heat exchange structure 120 is a wafer, the bonding process used to bond the heat exchange structure 120 to the circuit die 140 via the interface material layer 130 can be a wafer to wafer (W2W) bonding process.

Referring to FIG. 3, a cross section that illustrates an example temporary lid 300 that can be used during the fabrication of the example integrated circuit 100 is shown, in accordance with some aspects of the disclosure. The temporary lid 300 can be secured to the stiffener ring 152 via a first fastener 312 that is disposed in the first hole 153 and a second fastener 314 that is disposed in the second hole 155 during the fabrication process for the integrated circuit 100, as shown in FIG. 3. The first fastener 312 and the second fastener 314 can be implemented using various types of suitable fasteners (e.g., bolts, screws, etc.). The temporary lid 300 can be secured to the stiffener ring 152 during the fabrication process for the integrated circuit 100 after the bonding of the heat exchange structure 120 to the circuit die 140 via the interface material layer 130 (e.g., after completing the fusion bonding process or the reflow soldering process as detailed above). The use of the temporary lid 300 can help balance the coefficient of thermal expansion (CTE) mismatch between the substrate 164 and the SMS-DOI structure (e.g., the bonded heat exchange structure 120, the circuit die 140, and the interposer layer 162) and can help strengthen the stiffener ring 152 during its interaction with the substrate 164 during temperature changes that occur during the process of bonding the substrate 164 to the circuit board 180 (e.g., during a BGA surface mount technology (SMT) reflow process used to bond the substrate 164 to the circuit board 180, etc.).

The design of the temporary lid 300 can be engineered to seal the center window opening of the stiffener ring 152 and to reduce warpages of the integrated circuit 100. For example, design parameters associated with the temporary lid 300 that can change depending on the implementation of the integrated circuit 100 include the material used to form the temporary lid 300, the thickness of the temporary lid 300, the spacing of the first hole 153 and the second hole 155 in the stiffener ring 152, the number of fastener holes in the stiffener ring 152 (e.g., 4 holes, 8 holes, etc.), and the curvature of the temporary lid 300, among other possibilities. After the substrate 164 is bonded to the circuit board 180, the temporary lid 300 can be removed, and the seal 116, the cover plate 110, and the clamp 192 can be installed. The temporary lid 300 can be formed using various suitable materials, including using suitable metals (e.g., copper, aluminum, etc.), alloys, and/or other suitable materials, for example. Even though the temporary lid 300 may be removed during the fabrication process for the integrated circuit 100, the final structure of the integrated circuit 100 can still show evidence that the temporary lid 300 was used (e.g., the shape of the stiffener ring 152 in the final structure of the integrated circuit 100 may be altered, showing evidence that the temporary lid 300 was used in the fabrication process for the integrated circuit 100). Additionally, the temporary lid 300 can help to protect the heat exchange structure 120 from exposure to environment dusts, corrosive chemicals, and risks of contact damages during manufacturing processes.

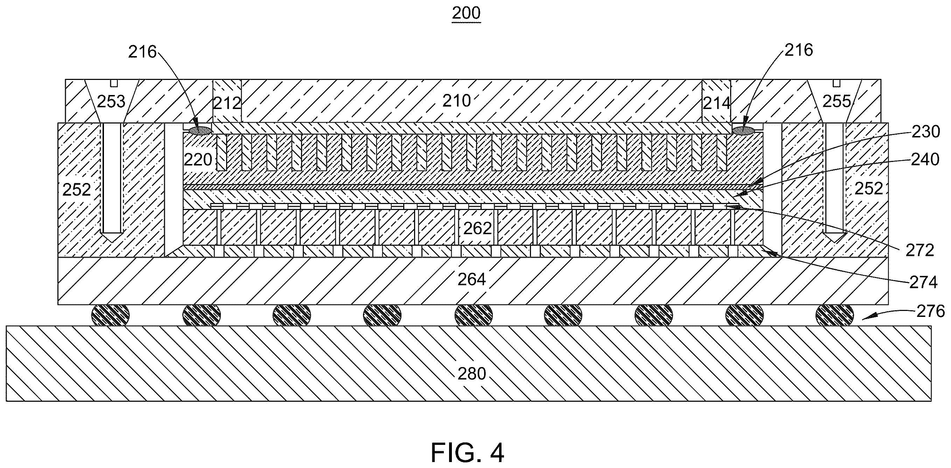

Referring to FIG. 4, a cross section that illustrates example components of another type of example integrated circuit 200 is shown, in accordance with some aspects of the disclosure. In general, the integrated circuit 200 can be similar to the integrated circuit 100. However, in the integrated circuit 200, a cover plate 210 can be secured to a stiffener ring 252 via a first fastener 253 and a second fastener 255. As a result, the integrated circuit 200 may not include structures like the clamp 192 and the pressure support plate 194 that can be included in the integrated circuit 100. The integrated circuit 200 can be designed for a variety of suitable purposes, and can be included in a variety of suitable types of electronic devices. For example, the integrated circuit 200 can be implemented in a data center to provide data processing and/or other functionality (e.g., via one or more CPUs, GPUs, etc.). The integrated circuit 200 can also be implemented in various types of personal computing devices (e.g., smartphones, personal computers, etc.) and networking devices (e.g., network switch devices, communications circuits. etc.). The integrated circuit 200 can be used for various AI applications (e.g., for training and/or inference).

As shown in FIG. 4, the integrated circuit 200 can include a cover plate 210, a heat exchange structure 220, a interface material layer 230, a circuit die 240, the stiffener ring 252, an interposer layer 262, and a substrate 264. Also, as shown in FIG. 4, the cover plate 210 can include a first port 212 and a second port 214, where the first port 212 can be used to receive a fluid for circulating through the heat exchange structure 220 and the second port 214 can then be used to remove the fluid after circulating through the heat exchange structure 120 (or vice versa). Additionally, as shown in FIG. 4, the integrated circuit 200 can include a seal 216 that can be disposed between the cover plate 210 and the heat exchange structure 220 for preventing leakage of the fluid. As can be seen in FIG. 4, the cover plate 210 is secured to the stiffener ring 252 via the first fastener 253 and the second fastener 255. The first fastener 253 and the second fastener 255 can be implemented using various types of suitable fasteners (e.g., bolts, screws, etc.), and can be disposed in holes formed in the stiffener ring 252 (e.g., similar to the first hole 153 and the second hole 155 of the stiffener ring 152 as shown in FIG. 1).

Moreover, as shown in FIG. 4, the integrated circuit 200 can include or can be mounted to a circuit board 280. Also shown in FIG. 4, the integrated circuit 200 can include an interconnect layer 272 disposed between the circuit die 240 and the interposer layer 262 and an interconnect layer 274 disposed between the interposer layer 262 and the substrate 264. Likewise, an interconnect layer 276 can be disposed between the substrate 264 and the circuit board 280. In some examples, the interconnect layer 276 and the circuit board 280 can be considered part of the integrated circuit 200 (e.g., when the integrated circuit 200 is considered as a higher level system circuit (chip) including other dies similar to the circuit die 240 mounted to the circuit board 280). In other examples, the interconnect layer 276 and the circuit board 280 can be considered part of a broader circuit in which the integrated circuit 200 is included (e.g., when the integrated circuit 100 is considered as a lower level circuit (chip) containing primarily the circuit die 240).

The circuit die 240 can be implemented in various suitable manners. For example, the circuit die 240 can be implemented using a single circuit die, and the circuit die 240 can also be implemented as using multiple circuit dies. The circuit die 240 can be formed using silicon material, for example, and the circuit die 240 can be formed using various suitable fabrication techniques. For example, multiple circuit dies can be combined to form the circuit die 240 using a 2.5D packaging technique. In such examples, the multiple circuit dies can be combined using through-silicon vias, such that the multiple circuit dies can be disposed side-by-side on the interconnect layer 272 (which is disposed on the interposer layer 262) and connected by way of the through-silicon vias. Additionally, the circuit die 240 can be formed by stacking multiple circuit dies (e.g., using a 3D packaging technique) on each other. For example, a die stack can be formed using techniques such as thermocompression bonding, hybrid copper bonding, and/or other suitable techniques. The circuit die 240 can also include various types and combinations of electrical components (e.g., transistors, resistors, capacitors, inductors, semiconductors, etc.), and the circuit die 240 can be designed to perform various suitable functions.

The stiffener ring 252 can be disposed on the substrate 264, as shown in FIG. 4, and can be implemented in various suitable manners. The stiffener ring 252 can, in general, provide structural support for the packaging of the integrated circuit 200. The stiffener ring 252 can be formed on a surface of the substrate 264 that is opposite the circuit board 280, as shown in FIG. 4. The stiffener ring 252 can be secured to the substrate 264 using various suitable techniques (e.g., using an adhesive). The stiffener ring 252 can be formed using various materials, including using suitable metal materials (e.g., copper, stainless steel, aluminum, etc.), alloys, and/or other suitable materials, for example. The circuit die 240 can generally be disposed within the stiffener ring 252 on the substrate 264, as shown in FIG. 4.

The cover plate 210 can be disposed on the heat exchange structure 220, as shown in FIG. 4, and can be implemented in various suitable manners. The cover plate 210 can be formed using various suitable materials such as, copper, aluminum, stainless steel, and/or other suitable materials, for example. The top surface of the cover plate 210 (opposite the heat exchange structure 220 from the perspective shown in FIG. 4) and the bottom surface of the cover plate 210 (closest to the heat exchange structure 220 from the perspective shown in FIG. 4) can both generally be flat surfaces. Additionally, the first port 212 and the second port 214 can be designed to hold up against the maximum pressure drops experienced by the integrated circuit 200 resulting from the flow of the fluid through the heat exchange structure 220 (e.g., from inlet to outlet, from opening to ambient, etc.). The cover plate 210 can generally be considered a manifold cover that is part of a cooling assembly for the integrated circuit 200. The cover plate 210 and the stiffener ring 252 can consist of essentially the same materials, or the cover plate 210 and the stiffener ring 252 can consist of different materials. The stiffener ring 252 and the cover plate 210 can, in some examples, be integrated into a single part, such that the first fastener 253 and the second fastener 255 may not be included. In such examples, efficiencies during the fabrication process for the integrated circuit 200 and/or improved performance of the integrated circuit 200 can be provided.

The seal 216 can likewise be implemented in various suitable manners. For example, the seal 216 can be implemented using adhesive material, using solder material, and/or using other suitable materials. The seal 216 can be implemented as an O-ring type seal, in some examples. Generally, the seal 216 can be disposed between the cover plate 210 and the heat exchange structure 220 to preventing leakage of the fluid flowing to, from, and through the heat exchange structure 220. The fluid can be any suitable type of fluid, including water, air, various types of coolants, and/or other types of fluids. The seal 216 can generally be designed to have the proper metallization and seal width for the particular implementation of the integrated circuit 200. Additionally, the height (thickness) of the seal 216 (e.g., as measured in the direction between the cover plate 210 and the heat exchange structure 220) can be set to a desired level during the fabrication process of the integrated circuit 200 (e.g., through compression, through mechanical stops, etc.), as deemed appropriate for the particular implementation of the integrated circuit 200.

The interposer layer 262 can be used to form various electrical connections within the integrated circuit 200. For example, as noted, the interposer layer 262 can be used to electrically connect multiple dies that are used to form the circuit die 240. Use of the interposer layer 262 can provide various advantages, including spreading connections to a wider pitch, providing a flexible interface, eliminating packaging layers from the integrated circuit 200, lowering latency between electrical connections, providing higher bandwidth density, providing efficient energy utilization, and/or other possible advantages, depending on the application. The circuit die 240, the interconnect layer 272, and the interposer layer 262 can cooperatively form a "die on interposer" (DOI) structure within the integrated circuit 200. In some implementations of the integrated circuit 200 (e.g., when the circuit die 240 is implemented as a single die), the interposer layer 262 and at least one of the interconnect layer 272 or the interconnect layer 274 may not be included as part of the integrated circuit 200.

The substrate 264 can be implemented in various suitable manners, and the substrate 264 can generally serve as a base for forming various components of the integrated circuit 200 thereon. For example, the substrate 264 can be formed using silicon material (e.g., crystalline silicon) and/or other suitable materials or combinations of materials. Additionally, the substrate 264 can be implemented using various fabrication technologies, such as using a silicon-on-insulator (SOI) structure, a bulk semiconductor structure, an alloy semiconductor, a compound semiconductor, germanium, and/or various other suitable materials and combinations thereof. The substrate 264 can generally be coupled to a lid to from a package for the integrated circuit 200. The circuit board 280 can likewise be implemented in various suitable manners. For example, the circuit board 280 can be implemented using various suitable types of printed circuit boards (PCBs). The circuit board 280 can also be implemented using various fabrication technologies, such as using an SOI structure, a bulk semiconductor structure, an alloy semiconductor, a compound semiconductor, germanium, and/or various other suitable materials and combinations thereof.

The interconnect layer 272, the interconnect layer 274, and the interconnect layer 276 can each be implemented in various suitable manners, depending on the particular implementation of the integrated circuit 200. For example, the interconnect layer 272 can be formed using approaches such as reflow bonding, as thermocompression bonding, hybrid copper bonding, and/or other suitable approaches. To help distribute forces during compression and to help with hydrostatic loading, the interconnect layer 272 can consist essentially of solid materials. The solid materials can include various suitable metals (e.g., copper, aluminum, etc.), metal alloys (e.g., solder, etc.), dielectric materials (e.g., silicon oxide, silicon dioxide, silicon nitride, aluminum oxide, etc.), and/or other suitable solid materials.

The interconnect layer 274 can be formed using a controlled chip collapse interconnection or by using bump metallization, for example. Additionally, the interconnect layer 274 can further include underfill material (e.g., epoxy, polymer, etc.). For example, the underfill material can be formed at least partially around the bumps or balls. Similar to the interconnect layer 272, the interconnect layer 274 can consist essentially of solid materials (e.g., metals, metal alloys, dielectric materials, etc.) to help distribute forces during compression and to help with hydrostatic loading. The interconnect layer 276 can likewise be formed using bump metallization, among other possible approaches, and can also include underfill material. Similar to the interconnect layer 272 and the interconnect layer 274, the interconnect layer 276 can consist essentially of solid materials (e.g., metals, metal alloys, dielectric materials, etc.) to help distribute forces during compression and to help with hydrostatic loading.

The heat exchange structure 220 can include a groove similar to the groove 126 and openings similar to the openings 122. In some implementations, the heat exchange structure 220 can consist essentially of silicon. For example, the heat exchange structure 220 can again be fabricated as a silicon microchannel support that is bonded to a die-on-interposer structure. The heat exchange structure 220 can be implemented as a die or a wafer, for example, among other possible implementations. The interface material layer 230 can be implemented in various suitable ways depending on the implementation of the integrated circuit 200. For example, the interface material layer 230 can include a dielectric material (e.g., silicon oxide, silicon dioxide, silicon nitride, aluminum oxide, etc.). In such examples, the interface material layer 230 can be made especially thin such that the interface material layer 230 has a low thermal resistance. When the interface material layer 230 includes a dielectric material, a thickness of the interface material layer 230 as measured in the direction between the circuit die 240 and the heat exchange structure 220 can be between 80 nanometers and 50 micrometers.

The interface material layer 230 can additionally or alternatively include a solder material (e.g., high temperature solder alloys such as indium silver, gallium, tin silver, tin copper, etc.). In such examples, the interface material layer 230 can also be made rather thin such that the interface material layer 230 has a low thermal resistance. The high thermal conductivity of the solder material can also lower the thermal resistance of the interface material layer 230 in such examples. When the interface material layer 230 includes a solder material, a thickness of the interface material layer 230 as measured in the direction between the circuit die 240 and the heat exchange structure 220 can be between 900 nanometers and 200 micrometers. Due to the circulation of cold fluid through the heat exchange structure 220, the heat exchange structure 220 can serve as a "cold plate" that can provide cooling for the circuit die 240 within the integrated circuit 200, for example.

The heat exchange structure 220 can be bonded to the circuit die 240 via the interface material layer 230 in various suitable manners during the fabrication process for the integrated circuit 200. For example, a fusion bonding process can be used, where a dielectric material can be applied (e.g., using various suitable deposition processes, etc.) to both a bottom surface of the heat exchange structure 220 (e.g., the surface closest to the circuit die 240) and a top surface of the circuit die 240 (e.g., the surface closest to the heat exchange structure 220). A chemical mechanical planarization process can then be used on both the bottom surface of the heat exchange structure 220 and the top surface of the circuit die 240 before using a fusion bonding process to bond the bottom surface of the heat exchange structure2120 to the top surface of the circuit die 240 via the interface material layer 230. During the fabrication process for the integrated circuit 200, a temporary lid similar to the temporary lid 330 detailed above can be used after reflow surface mounting of the substrate 264 to the circuit board 280.

As another example, a solder bonding process can be used, where metallization and solder plating can be applied (e.g., using various suitable processes) to both the bottom surface of the heat exchange structure 220 and the top surface of the circuit die 240 before using a reflow soldering process to bond the bottom surface of the heat exchange structure 220 to the top surface of the circuit die 240 via the interface material layer 230. In implementations where the heat exchange structure 220 is a die, the bonding process used to bond the heat exchange structure 220 to the circuit die 240 via the interface material layer 230 can be a die to wafer bonding process. In implementations where the heat exchange structure 220 is a wafer, the bonding process used to bond the heat exchange structure 220 to the circuit die 240 via the interface material layer 230 can be a wafer to wafer (W2W) bonding process.

Accordingly, as detailed above, the integrated circuit 100 and the integrated circuit 200 can include cooling assemblies that provide cooling for the circuit die 140 and the circuit die 240, respectively. In some previous approaches, the cooling functionality can rely on a rather modest pressure drop (e.g., less than 10 pounds per square inch (PSI)) across the heatsink. However, with an increased pressure drop, a more efficient heatsink can be provided because more fluid can be pushed through the heatsink. That said, it can be challenging to design a cooling assembly that holds up under such an increased pressure drop, at least in part because it can be difficult to design a cooling assembly with a functioning seal and with a thermal interface that has a low enough thermal conductivity.

The design of the cooling functionality in the integrated circuit 100 and the integrated circuit 200 can overcome these difficulties by delivering fluid directly to the heat exchange structure 120 and the heat exchange structure 220, respectively, where the heat exchange structure 120 and the heat exchange structure 220 can be fabricated as part of the same packaging process as the integrated circuit 100 and the integrated circuit 200. This design provides an alternative to approaches such as using cold plate technologies to provide circuit cooling. Instead of using a cold plate approach, the integrated circuit 100 and the integrated circuit 200 both use a chip direct liquid cooling (CDLC) approach. When the chip thermal design power is at or above the air cooling limit of around 1 kilowatt (kW) to 1.5 kW (and an associated heat flux density of around 125 W/cm²), the use of a chip direct liquid cooling approach may be required.

The use of cold plate technologies can require a rather thick layer of thermal interface material to bridge the interface topographical gaps. These gaps can be as high as 100 micrometers in certain locations (e.g., center, corner, etc.) of the contact interface due to the material coefficient of thermal expansion and flatness mismatches (e.g., copper vs. silicon, etc.) between the chip (e.g., a board reflow soldering mounted chip) and the metal cold plate. Additionally, this interface gap can change in application during the change of chip operating temperature due to the chip and the cold plate warpage changes. In some cases, organic thermal interface materials (e.g., phase change materials) can be used to fill the gaps. However, even in such cases, the thermal impedance can remain very high, especially at the large gap locations. Further, localized changes (e.g., increases, decreases) of the interface gap with temperature can cause a pump-out action that eventually can deplete the phase change organic thermal interface materials and lead to thermal failure. As such, a very thin (e.g., below 25 micrometers) bonding between a cold plate and a silicon die with consistent bond line thickness throughout the lifecycle temperature ranges of the chip (e.g., from manufacturing, to testing, and to applications) is desirable.

Further, exposure to high temperature (e.g., greater than 245 degrees Celsius) processes (e.g., reflow soldering of BGA devices) can damage the structural and mechanical integrity of some previous metal cold plate assembly designs. The chip to cold plate bond line can be damaged (e.g., with cracks, delamination, etc.) during the reflow surface mount process as a result of the mismatched coefficient of thermal expansion of the materials in the cold plate metal and the silicon chip. To avoid the chip to cold plate bond line damages, the cold plate heat sink assembly can be attached to a BGA chip after reflow surface mounting. However, this can still cause large gaps at the interface, as detailed above. Accordingly, a cold plate fixture that includes the same material coefficient of thermal expansion as the chip could sustain the high temperature manufacturing process during the chip packaging assembly reflow process as well as the board assembly reflow process.

The cooling functionality associated with the design of the integrated circuit 100 and the integrated circuit 200 can be critical for enabling high-power devices (e.g., greater than 1 kW) used in data centers for high-density board applications (e.g., greater than 10 kW). The design of the integrated circuit 100 and the integrated circuit 200 can be advantageous relative to previous approached for several reasons. The thin cold plate to silicon bond line (e.g., the interface material layer 130 and the interface material layer 230) can significantly lower and minimize the thermal path resistance between the cold plate (e.g., the heat exchange structure 120 and the heat exchange structure 220) and the silicon (e.g., the circuit die 140 and the circuit die 240). Also, the heat exchange structure 120 and the heat exchange structure 220 can have generally the same (or similar) coefficient of thermal expansion as the circuit die 140 and the circuit die 240 to minimize interface thermomechanical stresses and improve both the reliability and performance in the application environment. Additionally, the cover plate 110 and the cover plate 210 can be attached to the package after the last high temperature manufacturing process step (e.g., the board reflow surface mounting step) has been completed.

Further, the temporary lid 330 (and the analogous temporary lid used with the integrated circuit 200) can protect the heat exchange structure 120 (and the heat exchange structure 220) from things such as contamination, corrosion, and other damages that can occur during the package assembly and the application board system assembly processes. Moreover, the cover plate 110 and the cover plate 210 can further enhance the flatness of the associated SMS-DOI structures and reduce high temperature warpage that can cause yield loss during the flip chip attachment to the substrates. Additionally, the temporary lid 330 (and the analogous temporary lid used with the integrated circuit 200) can enhance the package flatness and reduce high temperature warpage that can cause yield loss during BGA reflow surface mount on application system boards (e.g., the circuit board 180 and the circuit board 280). Also, the package-integrated SMS cold plate (e.g., the heat exchange structure 120 and the heat exchange structure 220) can be package-sized such that is more compact than some alternate cold plate attachment designs that feature cold plates larger than the device footprint areas on the application board for attachment. Other advantages can also be provided by the design of the integrated circuit 100 and the integrated circuit 200.

## Claims

1. An integrated circuit, comprising:
a circuit die disposed on a substrate of the integrated circuit;
a stiffener ring disposed on the substrate of the integrated circuit;
a heat exchange structure disposed on the circuit die, wherein the heat exchange structure comprising openings for circulating a fluid therethrough;
a cover plate disposed on the heat exchange structure, the cover plate comprising a first port to provide the fluid to the heat exchange structure and a second port to remove the fluid from the heat exchange structure; and
a clamp secured to cover plate.

2. The integrated circuit of claim 1, comprising
a seal disposed between the cover plate and the heat exchange structure.

3. The integrated circuit of claim 1 or 2, comprising
an interface material layer disposed between the heat exchange structure and the circuit die;

4. The integrated circuit of claim 3, wherein:
the interface material layer comprises a dielectric material; and
a thickness of the interface material layer as measured in a direction between the circuit die and the heat exchange structure is between 80 nanometers and 50 micrometers.

5. The integrated circuit of claim 3, wherein:
the interface material layer comprises a metal material or a metal alloy material comprising solder; and
a thickness of the interface material layer as measured in a direction between the circuit die and the heat exchange structure is between 900 nanometers and 200 micrometers.

6. The integrated circuit of claim 3, wherein:
the interface material layer is disposed directly on the circuit die; and
the heat exchange structure is disposed directly on the interface material layer.

7. The integrated circuit of any one of the preceding claims, comprising an interposer layer disposed between the circuit die and the substrate.

8. The integrated circuit of any one of the preceding claims, wherein
the stiffener ring, the cover plate, and the clamp are integrated into a single part.

9. The integrated circuit of any one of the preceding claims, wherein
the cover plate is secured to the stiffener ring.

10. The integrated circuit of any one of the preceding claims, wherein
the circuit die is disposed within the stiffener ring on the substrate of the integrated circuit.

11. The integrated circuit of any one of the preceding claims, wherein
the heat exchange structure consists essentially of silicon.

12. The integrated circuit of any one of the preceding claims, comprising
a printed circuit board substrate on which the substrate is disposed on and interconnected to;
wherein in particular
the printed circuit board substrate is disposed on a pressure support plate.

13. An integrated circuit, comprising:
a first substrate;
a circuit die disposed on the first substrate;
a stiffener ring disposed on the first substrate;
a heat exchange structure disposed on the circuit die, wherein the heat exchange structure comprises openings for circulating a fluid therethrough;
a cover plate disposed on the heat exchange structure, the cover plate comprising a first port to provide the fluid to the heat exchange structure and a second port to remove the fluid from the heat exchange structure;
a clamp secured to the cover plate;
a second substrate on which the first substrate is disposed on and interconnected to; and
a pressure support plate on which the second substrate is disposed.

14. The integrated circuit of claim 13, comprising at least one of the following features:
(A) a seal disposed between the cover plate and the heat exchange structure;
(B) an interface material layer disposed between the heat exchange structure and the circuit die, wherein the interface material layer comprises silicon oxide or silicon carbon-nitride; and
a thickness of the interface material layer as measured in a direction between the circuit die and the heat exchange structure is between 80 nanometers and 50 micrometers;
(C) an interface material layer disposed between the heat exchange structure and the circuit die, wherein the interface material layer comprises a metal material or a metal alloy material comprising solder; and
a thickness of the interface material layer as measured in a direction between the circuit die and the heat exchange structure is between 900 nanometers and 200 micrometers;
(D) wherein both the stiffener ring and the cover plate are integrated into a single part.

15. An integrated circuit, comprising:
a circuit die disposed on a substrate of the integrated circuit;
a stiffener ring disposed on the substrate of the integrated circuit;
a heat exchange structure disposed on the circuit die, wherein the heat exchange structure comprising openings for circulating a fluid therethrough;
a cover plate disposed on the heat exchange structure, the cover plate comprising a first port to provide the fluid to the heat exchange structure and a second port to remove the fluid from the heat exchange structure;
a clamp secured to cover plate; and
a seal disposed between the cover plate and the heat exchange structure;
wherein in particular
the seal comprises an adhesive material.
